# EUROPÄISCHE PATENTANMELDUNG

(11) **EP 4 468 584 A1**
(43) Veröffentlichungstag der Anmeldung: **27.11.2024**
(21) Anmeldenummer: 23175412.8
(22) Anmeldetag: 25.05.2023
(51) Int. Cl.: H02M 1/32, H02M 7/483, H02M 3/00

(54) **ZELLBASIERTER MODULARER BREMSTELLER FÜR MITTEL- UND HOCHSPANNUNGSANWENDUNGEN**

(71) Anmelder: Siemens Energy Global GmbH & Co. KG, 81739 München (DE)
(72) Erfinder: Kapelke, Martin, 90429 Nürnberg (DE); Schrammel, Christian, 90559 Burgthann (DE); Euler, Ingo, 91056 Erlangen (DE)

(57) **Zusammenfassung**

Die Erfindung betrifft eine Vorrichtung (20) zum Umwandeln von Elektroenergie in Wärme im Bereich der Mittel- und Hochspannungstechnik mit einem ersten Umwandlungsmodul (1), umfassend eine erste Widerstandsbaugruppe (6), die mit einer ersten Anschlussklemme (X1) des Umwandlungsmoduls verbunden ist und eine Mehrzahl von Widerstandsscheiben aufweist, sowie einen ersten Halbleiterschalter (7), mittels dessen ein Stromfluss durch die erste Widerstandsbaugruppe gesperrt oder erlaubt werden kann, und der mit einer zweiten Anschlussklemme (X2) des Umwandlungsmoduls verbunden ist. Die Erfindung zeichnet sich dadurch aus, dass sie ferner eine zweite Widerstandsbaugruppe (9), die mit der ersten Anschlussklemme des Umwandlungsmoduls verbunden ist und eine Mehrzahl von Widerstandsscheiben aufweist, sowie einen zweiten Halbleiterschalter (10) umfasst, mittels dessen ein Stromfluss durch die zweite Widerstandsbaugruppe gesperrt oder erlaubt werden kann, und der mit der zweiten Anschlussklemme des Umwandlungsmoduls verbunden ist, wobei die Widerstandsscheiben der ersten und der zweiten Widerstandsbaugruppe in einem gemeinsamen Stapel (35) zwischen einer ersten und einer zweiten Kühlplatte (36, 37) angeordnet sind, der nachfolgend als erster Stapel bezeichnet wird, wobei der erste Stapel ferner eine mittlere Kühlplatte (38) aufweist, die die Widerstandsscheiben der ersten Widerstandsbaugruppe von den Widerstandsscheiben der zweiten Widerstandsbaugruppe trennt, wobei die erste Kühlplatte mit dem ersten Halbleiterschalter, die zweite Kühlplatte mit dem zweiten Halbleiterschalter und die mittlere Kühlplatte mit der ersten Anschlussklemme des Umwandlungsmoduls elektrisch verbunden sind. Die Erfindung betrifft ferner eine Umrichteranordnung mit der erfindungsgemä-ßen Vorrichtung.

## Beschreibung

Die Erfindung betrifft eine Vorrichtung zum Umwandeln von Elektroenergie in Wärme im Bereich der Mittel- und Hochspannungstechnik mit einem ersten Umwandlungsmodul, umfassend eine erste Widerstandsbaugruppe, die mit einer ersten Anschlussklemme des Umwandlungsmoduls verbunden ist und eine Mehrzahl von Widerstandsscheiben aufweist, sowie einen ersten Halbleiterschalter, mittels dessen ein Stromfluss durch die erste Widerstandsbaugruppe gesperrt oder erlaubt werden kann, und der mit einer zweiten Anschlussklemme des Umwandlungsmoduls verbunden ist.

Eine solche Vorrichtung hat in den meisten Anwendungen die Aufgabe, eine in einem Übertragungsnetz überschüssige Elektroenergie abzubauen, insbesondere indem die Elektroenergie in Wärme umgewandelt wird. Dies kann zu einer Stabilisierung des Übertragungsnetzes beitragen, falls die überschüssige Energie nicht in ein benachbartes Netz übertragen, in einem Energiespeicher gespeichert oder durch eine Last aufgenommen werden kann.

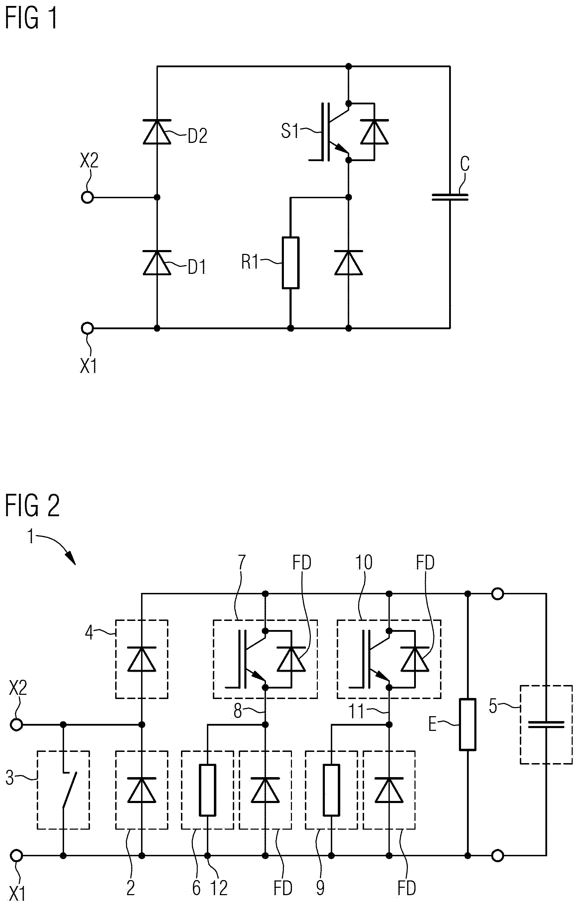

Eine eingangs genannte Vorrichtung ist aus der WO 2010/023127 A2 bekannt. Die bekannte Vorrichtung weist Umwandlungsmodule, die in einer Reihenschaltung zwischen zwei Gleichspannungspolen einer HGÜ-Übertragungsverbindung schaltbar bzw. im Betrieb geschaltet sind. Ein Umwandlungsmodul der bekannten Vorrichtung ist in Figur 1 gezeigt. Es umfasst eine erste Anschlussklemme X1 und eine zweite Anschlussklemme X2 und eine erste Diode D1 zwischen den Anschlussklemmen. In einem Widerstandsbaugruppenzweig sind eine Widerstandsbaugruppe R1 sowie ein Halbleiterschalter S1 angeordnet, der über eine zweite Diode D2 mit der ersten Anschlussklemme X1 verbunden ist. Ein Energiespeicher (Kondensator) C ist in einer Parallelschaltung zu dem Widerstandsbaugruppenzweig angeordnet. Jedes Umwandlungsmodul bildet eine eigenständige Einheit zur thermischen Energieumwandlung, die über eine zentrale Regelung weitgehend unabhängig von den weiteren in Reihe geschalteten Umwandlungsmodulen die Leistungsaufnahme der Vorrichtung (die auch als DC-Chopper bezeichnet wird) regelt. Die Regelung schaltet die im Powermodul enthaltenen Halbleiterschalter (im gezeigten Beispiel als IGBTs realisiert) ein, wodurch ein Strompfad über Widerstände führt. Über die dort anliegende Spannung erfolgt die thermische Energieumwandlung.

Die Aufgabe der Erfindung ist es, eine solche Vorrichtung vorzuschlagen, die möglichst effektiv in der Energieumwandlung, zuverlässig und einfach zu warten ist.

Die Aufgabe wird bei einer artgemäßen Vorrichtung erfindungsgemäß dadurch gelöst, dass die Vorrichtung ferner eine zweite Widerstandsbaugruppe, die mit der ersten Anschlussklemme des Umwandlungsmoduls verbunden ist und eine Mehrzahl von Widerstandsscheiben aufweist, sowie einen zweiten Halbleiterschalter umfasst, mittels dessen ein Stromfluss durch die zweite Widerstandsbaugruppe gesperrt oder erlaubt werden kann, und der mit der zweiten Anschlussklemme des Umwandlungsmoduls verbunden ist, wobei die Widerstandsscheiben der ersten und der zweiten Widerstandsbaugruppe in einem gemeinsamen Stapel zwischen einer ersten und einer zweiten Kühlplatte angeordnet sind, der nachfolgend als erster Stapel bezeichnet wird, wobei der erste Stapel ferner eine mittlere Kühlplatte aufweist, die die Widerstandsscheiben der ersten Widerstandsbaugruppe von den Widerstandsscheiben der zweiten Widerstandsbaugruppe trennt, wobei die erste Kühlplatte mit dem ersten Halbleiterschalter, die zweite Kühlplatte mit dem zweiten Halbleiterschalter und die mittlere Kühlplatte mit der ersten Anschlussklemme des Umwandlungsmoduls elektrisch verbunden sind. Dementsprechend umfasst ein Umwandlungsmodul zwei (oder mehr) Widerstandsbaugruppen in zwei Widerstandsbaugruppenzweigen, die parallel zueinander angeordnet sind. Auf diese Weise kann die Menge an umgewandelter Energie vorteilhaft erhöht werden (diese liegt meist oberhalb von 1MJ). Ferner sind die beiden Widerstandsbaugruppen gemeinsam in einem Stapel zwischen Kühlplatten angeordnet. Die Kühlplatten können aktiv gekühlt werden, so dass die Temperatur der Widerstandsbaugruppen vorteilhaft gesenkt werden kann und diese bei der Energieumwandlung effizienter sind. Die Kühlplatten können zudem als Anschlüsse der Widerstandsbaugruppen verwendet werden. Dies vereinfacht den Aufbau der Vorrichtung und erleichtert deren Wartung. Die Wärmeübergänge und das Kühlsystem können so ausgelegt werden, dass die Wärmeabgabe über einen Zeitraum von unter 60 oder gar unter 40 Minuten erfolgt, bis die am schlechtesten gekühlten Widerstandsscheiben zumindest 90% bzw. 95% der aufgenommenen Energie wieder abgegeben haben.

Gemäß einer Ausführungsform der Erfindung umfassen die erste und die zweite Widerstandsbaugruppe jeweils weitere Widerstandsscheiben, wobei die weiteren Widerstandsscheiben der ersten und der zweiten Widerstandsbaugruppe in einem gemeinsamen zweiten Stapel zwischen der ersten und der zweiten Kühlplatte angeordnet sind. Die mittlere Kühlplatte trennt die weiteren Widerstandsscheiben der ersten Widerstandsbaugruppe von den weiteren Widerstandsscheiben der zweiten Widerstandsbaugruppe. Der zweite Stapel ist gemäß dieser Ausführungsform parallel zu dem ersten Stapel angeordnet. Demnach bestehen die Widerstandsbaugruppen aus zwei (oder mehr) parallel zueinander angeordneten Stapeln mehrerer in Reihe geschalteter Widerstandsscheiben, wodurch eine höhere Stromaufnahme durch die Vorrichtung ermöglicht ist.

Zweckmäßigerweise sind der ersten Widerstandsbaugruppe eine erste Diode, der zweiten Widerstandsbaugruppe eine zweite Diode parallelgeschaltet. Ein Stromfluss entgegen der Durchlassrichtung des der jeweiligen Widerstandsgruppe zugeordneten Halbleiterschalters (in den meisten Fällen handelt es sich dabei um einen Fehlerstrom) erfolgt damit über die erste bzw. zweite Diode.

Einige oder auch alle Widerstandsscheiben können als zylinderförmige Keramik-Kohlenstoff-Widerstandsscheiben ausgebildet sein. Das Volumen der Widerstandsscheiben sowie deren maximal zulässige Temperatur und thermische Kapazität bestimmen im Allgemeinen die Energieaufnahmemenge einer Widerstandsbaugruppe. Beispielsweise können 4 parallele Stapel zu je 4 Widerstandsscheiben einen Energieumsatz von mehr als 2MJ erlauben.

Geeigneterweise weisen der erste und/oder der zweite Stapel jeweils höchstens zehn Widerstandsscheiben auf. Eine geringere Zahl an eingesetzten Widerstandsscheiben pro Stapel verringern einerseits zwar den Energieumsatz, anderseits kann auf diese Weise der Stapel besser bzw. schneller gekühlt werden, so dass die Vorrichtung effektiver arbeiten kann.

Gemäß einer Ausführungsform der Erfindung sind die erste, die zweite und die mittlere Kühlplatte an einen gemeinsamen Kühlkreislauf angeschlossen. Die Kühlplatten können zumindest aus Aluminium gefertigt sein. Zweckmäßigerweise ist die Widerstandsbaugruppe oben und unten mit Aluminiumkühlplatten abgeschlossen. Diese sind wasserdurchströmt und an ein Kühlsystem angeschlossen. Sie können hydraulisch (bsp. untereinander) in Reihe oder parallelgeschaltet sein. Sie bilden geeigneterweise elektrische Anschlusspunkte der Widerstandsbaugruppe aus. Die Seiten der Widerstandsbaugruppe können mit Platten aus glasfaserverstärkten Kunststoff abgeschlossen sein. Die Wärmeabgabe der Widerstandsscheiben erfolgt über die Kühlplatten an das Kühlsystem und/oder über natürliche Konvektion an die Umgebungsluft. Die Aluminiumkühlplatten können des Weiteren über Kunststoffschläuche an Verteilrohre für Zu- und Rücklauf angeschlossen sein.

Der erste und der zweite Halbleiterschalter können jeweils abschaltbare Halbleiterschalter sein, beispielsweise IGBTs, IGCTs oder andere geeignete Halbleiterschalter.

Vorzugsweise umfasst das erste Umwandlungsmodul ferner einen Energiespeicher, der in einer Parallelschaltung zum ersten Halbleiterschalter und der ersten Widerstandsbaugruppe angeordnet ist. Mittels des Energiespeichers kann an den Anschlussklemmen des Umwandlungsmoduls eine definierte Spannung (geeigneterweise die Energiespeicherspannung) erzeugt werden.

Gemäß einer Ausführungsform der Erfindung umfasst die Vorrichtung ferner ein zweites Umwandlungsmodul, das elektrisch in Reihe zum ersten Umwandlungsmodul geschaltet ist, wobei das erste und das zweite Umwandlungsmodul in einer Etage einer Tragestruktur angeordnet sind, wobei das zweite Umwandlungsmodul eine dritte Widerstandsbaugruppe und eine vierte Widerstandsbaugruppe umfasst, wobei die dritte Widerstandsbaugruppe in der Tragestruktur oberhalb der ersten Widerstandsbaugruppe und von dieser elektrisch isoliert angeordnet ist und die vierte Widerstandsbaugruppe in der Tragestruktur oberhalb der zweiten Widerstandsbaugruppe und von dieser elektrisch isoliert angeordnet ist. Insbesondere können die dritte und die vierte Widerstandsgruppe in der Tragestruktur oberhalb der ersten und der zweiten Widerstandsgruppe angeordnet sein. Gemäß dieser Ausführungsform ist eine besonders effektive Anordnung der Bauelemente der Vorrichtung bereitgestellt. Widerstandsbaugruppen, die zwei unterschiedlichen Umwandlungsmodulen zugeordnet sind, sind in einem gemeinsamen Einbauplatz innerhalb der Tragestruktur untereinander angeordnet. Auf diese Weise kann vorteilhaft die Zugänglichkeit der Verbindungen (Stromleiter, Stromschienen, Lichtwellenleiter) und Schläuche des Kühlsystems verbessert werden, so dass die Montage und die Wartung der Vorrichtung weiter erleichtert wird.

Die Erfindung betrifft ferner eine Umrichteranordnung, die einen Umrichter mit einer Wechselspannungsseite zum Verbinden mit einem Wechselspannungsnetz und einer Gleichspannungsseite umfasst.

Die Aufgabe der Erfindung ist es, eine solche Umrichteranordnung anzugeben, die eine möglichst zuverlässige Spannungswandlung und Energieübertragung ermöglicht.

Die Aufgabe wird bei einer artgemäßen Umrichteranordnung erfindungsgemäß dadurch gelöst, dass die Umrichteranordnung ferner eine erfindungsgemäße Vorrichtung zum Umwandeln von Elektroenergie in Wärme umfasst, die mit der Gleichspannungsseite des Umrichters verbunden ist.

Die Vorteile der erfindungsgemäßen Umrichteranordnung ergeben sich insbesondere aus den Vorteilen, die im Zusammenhang mit der erfindungsgemäßen Vorrichtung bereits erörtert wurden. I

In einer Anwendung der Umrichteranordnung kann der Umrichter wechselspannungsseitig mit einer Energieerzeugungseinrichtung verbunden sein. Die Energieerzeugungseinrichtung kann beispielsweise ein Windpark, insbesondere ein offshore-Windpark sein. Der Umrichter hat die Aufgabe, die im Windpark erzeugte Energie in eine Hochspannungsgleichstromübertragungsverbindung (HGÜ) einzuspeisen und mittels der HGÜ (und eines weiteren Umrichters) in ein Versorgungsnetz zu übertragen. Mittels der mit dem Umrichter verbundenen Vorrichtung kann vorteilhaft überschüssige Energie (bei Überproduktion im Windpark), die nicht in das Versorgungsnetz eingespeist werden kann, effektiv in Wärme umgewandelt werden.

Die Erfindung wird nachfolgend anhand von Ausführungsbeispielen der Figuren 2 bis 5 weiter erläutert.
Figur 2 zeigt ein Ausführungsbeispiel einer erfindungsgemäßen Vorrichtung in einer schematischen Darstellung;
Figur 3 zeigt ein weiteres Ausführungsbeispiel einer erfindungsgemäßen Vorrichtung in einer schematischen Darstellung;
Figur 4 zeigt ein Beispiel von Widerstandsbaugruppen in einer schematischen Darstellung;
Figur 5 zeigt ein Beispiel einer erfindungsgemäßen Umrichteranordnung in einer schematischen Darstellung.

In Figur 2 ist ein Umwandlungsmodul 1 dargestellt, das mit anderen, gleichartig aufgebauten Umwandlungsmodulen eine Vorrichtung V zum Umwandeln elektrischer Energie in Wärme ausbildet. Ähnlich zum Umwandlungsmodul der Figur 1 umfasst das Umwandlungsmodul 1 zwei Anschlussklemmen X1, X2, die dazu ausgebildet sind, das Umwandlungsmodul 1 in einer Reihenschaltung mit weiteren Umwandlungsmodulen unter Ausbildung der Vorrichtung V zwischen die Gleichspannungspole einer Gleichspannungsverbindung zu schalten. Zwischen den Anschlussklemmen X1, X2 ist ein Brückenzweig geschaltet, in dem eine erste Diode 2 angeordnet ist. Parallel zu der ersten Diode 2 zwischen den Anschlussklemmen X1, X2 ist zudem ein Überbrückungsschalter 3 angeordnet, mittels dessen das Umwandlungsmodul 1 beispielsweise im Fehlerfall überbrückt werden kann.

Das Umwandlungsmodul 1 weist ferner eine zweite Diode 4 sowie einen Energiespeicher (im dargestellten Beispiel einen Kondensator) 5 auf. Parallel zum Energiespeicher 5 ist ein Entladewiderstand E zum Entladen des Energiespeichers 5 angeordnet.

Des Weiteren umfasst das Umwandlungsmodul 1 eine erste Widerstandsbaugruppe 6, die mit der ersten Anschlussklemme X1 des Umwandlungsmoduls 1 verbunden ist und eine Mehrzahl von Widerstandsscheiben aufweist, sowie einen ersten Halbleiterschalter 7, mittels dessen ein Stromfluss durch die erste Widerstandsbaugruppe 6 gesperrt oder erlaubt werden kann, und der mit einer zweiten Anschlussklemme X2 des Umwandlungsmoduls verbunden ist. Der erste Halbleiterschalter 7 und die erste Widerstandsbaugruppe 6 sind in einem ersten Schaltzweig 8 angeordnet, der parallel zum Energiespeicher 5 geschaltet ist. Zugleich umfasst das Umwandlungsmodul 1 eine zweite Widerstandsbaugruppe 9, die mit der ersten Anschlussklemme X1 des Umwandlungsmoduls 1 verbunden ist und eine Mehrzahl von Widerstandsscheiben aufweist, sowie einen zweiten Halbleiterschalter 10, mittels dessen ein Stromfluss durch die zweite Widerstandsbaugruppe 9 gesperrt oder erlaubt werden kann, und der mit einer zweiten Anschlussklemme X2 des Umwandlungsmoduls 1 verbunden ist. Der zweite Halbleiterschalter 10 und die zweite Widerstandsbaugruppe 9 sind in einem zweiten Schaltzweig 11 angeordnet, der, wie auch der erste Schaltzweig 8, parallel zum Energiespeicher 5 geschaltet ist. Den Halbleiterschaltern 7, 10 und den Widerstandsbaugruppen 6, 9 sind jeweils eigene Freilaufdioden FD (anti-)parallel geschaltet. Ein Aktivieren der Halbleiterschalter 7, 10 erlaubt einen Stromfluss durch die zugeordneten Widerstandsbaugruppen 6, 9, wodurch elektrische Energie in Wärme umgewandelt wird und mittels aktiver Kühlung und/oder Konvektion an die Umgebung abgegeben wird.

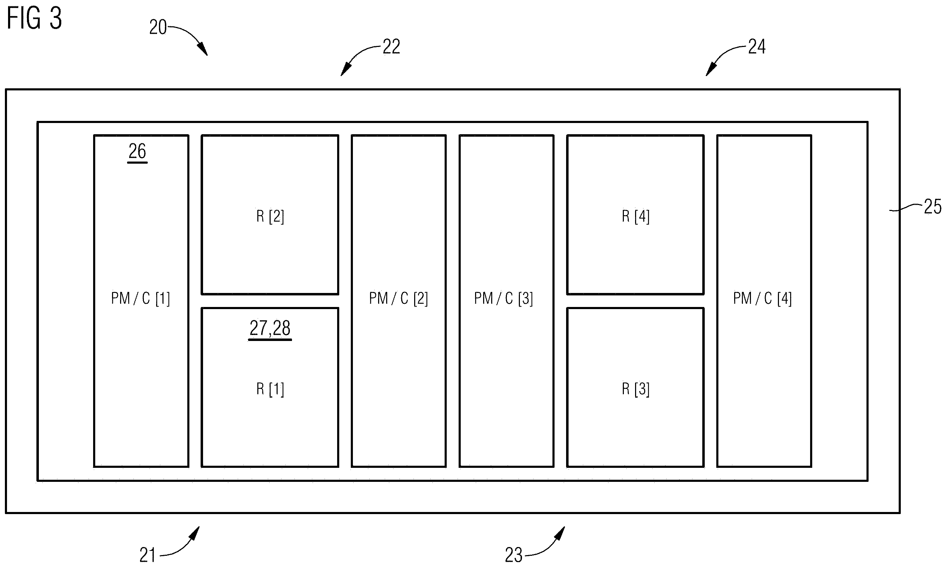

In Figur 3 ist eine Vorrichtung 20 zum Umwandeln von Elektroenergie in Wärme mit vier Umwandlungsmodulen 21-24, die in einer Etage einer Tragestruktur 25 angeordnet sind (die Figur 3 zeigt eine Vorderansicht der Anordnung). In Figur 3 sind die Umwandlungsmodule 21-24 gleichartig aufgebaut. Deren Aufbau entspricht im Wesentlichen dem Aufbau des Umwandlungsmoduls 1 der Figur 2.

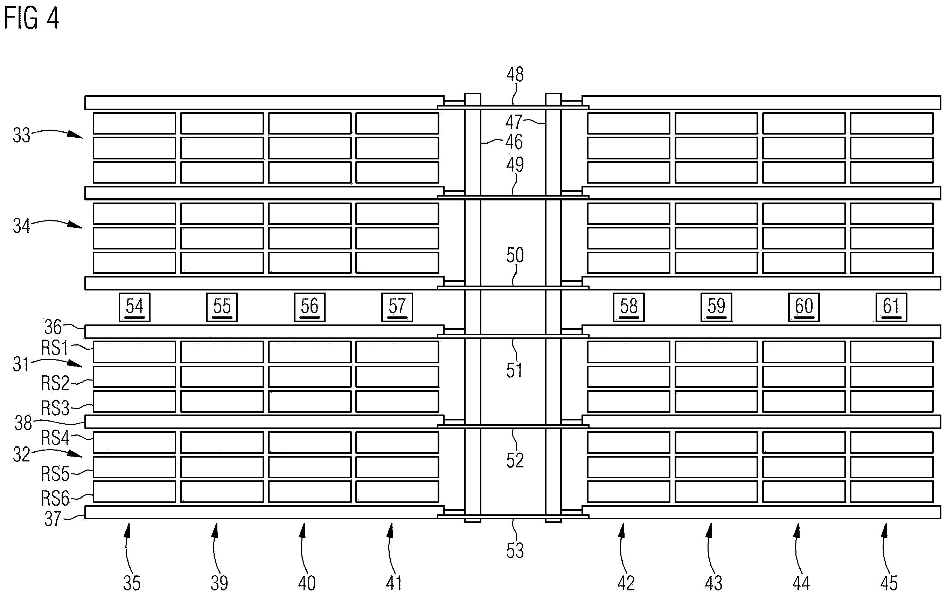

Das erste Umwandlungsmodul 21 umfasst ein sogenanntes Powermodul 26, das die Halbleiterschalter des Umwandlungsmoduls 21 umfasst, die in einem separaten Gehäuse untergebracht sind. Ferner umfasst das erste Umwandlungsmodul 21 eine erste und eine zweite Widerstandsbaugruppe 27, 28, die in einer eigenen Anordnung neben dem Powermodul 26 angeordnet sind. Es ist erkennbar, dass die Widerstandsbaugruppen zweier benachbarter Umwandlungsmodule in der Tragestruktur übereinander angeordnet sind. Auf den Aufbau der Widerstandsbaugruppen selbst wird in der nachfolgenden Figur 4 näher eingegangen.

In Figur 4 sind eine erste Widerstandsbaugruppe 31, eine zweite Widerstandsbaugruppe 32, eine dritte Widerstandsbaugruppe 33 und eine vierte Widerstandsbaugruppe 34 in einer Seitenansicht dargestellt. Die erste und die zweite Widerstandsbaugruppe 31, 32 sind einem ersten Umwandlungsmodul (beispielsweise dem ersten Umwandlungsmodul 21 der Figur 3) zugeordnet. Die dritte und die vierte Widerstandsbaugruppe 33, 34 sind einem zweiten Umwandlungsmodul (bsp. dem zweiten Umwandlungsmodul 22 der Figur 3) zugeordnet.

Die erste Widerstandsbaugruppe 31 umfasst in einem ersten Stapel 35 drei Widerstandsscheiben RS1-3. Der erste Stapel 35 umfasst ferner drei Widerstandsscheiben RS4-6 der zweiten Widerstandsbaugruppe 32. Die dem ersten Stapel 35 zugeordneten Widerstandsscheiben RS1-6 sind zwischen einer ersten (oberen) Kühlplatte 36 und einer zweiten (unteren) Kühlplatte 37 angeordnet (und mechanisch verspannt). Eine mittlere Kühlplatte 38 trennt die Widerstandsscheiben R1-3 der ersten Widerstandsbaugruppe 31 von den Widerstandsscheiben RS4-6 der zweiten Widerstandsbaugruppe 32.

Die erste und die zweite Widerstandsbaugruppe 31, 32 umfassen weitere sieben Stapeln 39-45 mit Widerstandsscheiben, die parallel zum ersten Stapel 35 zwischen Kühlplatten angeordnet sind. Vordere und hintere Kühlplatten sind miteinander mittels Stromschienen 48-53 elektrisch verbunden. Die Kühlplatten 36-38 sind an Kunststoffleitungen 46, 47 eines aktiven, fluidbasierten Kühlkreislaufes angeschlossen. Die Seiten der Widerstandsbaugruppen werden mittels Platten aus glasfaserverstärktem Kunststoff geschlossen (in Figur 4 nicht dargestellt). Die Wärmeübergänge und das Kühlsystem sind derart ausgelegt, dass die Wärmeabgabe über einen Zeitraum von weniger als 60 Minuten erfolgt, bis die am schlechtesten gekühlten Widerstandsscheiben mindestens 90%, besonders bevorzugt mindestens 95% der eingetragenen Energie wieder abgegeben haben. Die erste und die zweite Widerstandsbaugruppe 31, 32 sind von den Widerstandsbaugruppen 33, 34 mittels Isolatoren 54-61 getrennt.

Bezogen auf den Aufbau eines Umwandlungsmoduls 1 der Figur 2 sind die erste Kühlplatte 36 mit dem ersten Halbleiterschalter 7, die zweite Kühlplatte 37 mit dem zweiten Halbleiterschalter 10 und die mittlere Kühlplatte 38 mit der ersten Anschlussklemme X1 des Umwandlungsmoduls 1 bzw. mit einem Potenzialpunkt, der in Figur 2 mit dem Bezugszeichen 12 gekennzeichnet ist, elektrisch verbunden.

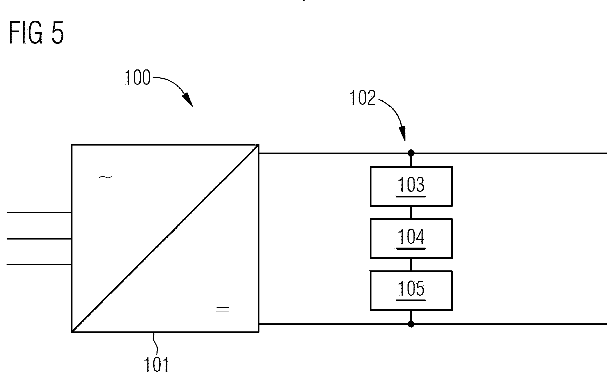

In Figur 5 ist eine Umrichteranordnung 100 dargestellt. Die Umrichteranordnung umfasst einen Umrichter 101, der wechselspannungsseitig mit einem Wechselspannungsnetz und gleichspannungsseitig mit einer Gleichspannungsverbindung verbindbar ist. Parallel zum Umrichter 101 zwischen beiden Gleichspannungspolen der Gleichspannungsverbindung ist eine Vorrichtung 102 zum Umwandeln elektrischer Energie in Wärme angeordnet. Die Vorrichtung 102 weist eine Reihenschaltung von Umwandlungsmodulen 103-105. Die Umwandlungsmodule 103-105 können gleichartig aufgebaut sein, jeweils beispielsweise entsprechend dem Umwandlungsmodul 1 der Figur 2. Der Umrichter 101 wandelt in dem in Figur 5 gezeigten Beispiel die mittels eines Windparks erzeugte Wechselspannung (beispielsweise auf See) in eine Gleichspannung zum Transport und Einspeisung in ein Versorgungsnetz (beispielsweise an Land). Erhöht sich die Spannung in der Gleichspannungsverbindung über ein zulässiges Maß hinaus (weil nicht die gesamte im Windpark erzeugte Energie in das Versorgungsnetz eingespeist werden kann), so kann ein Teil der Elektroenergie mittels der Vorrichtung 102 in Wärme umgewandelt werden. Auf diese Weise kann zu einer Stabilisierung der Energieübertragung bzw. der Netze beigetragen werden.

## Patentansprüche

1. Vorrichtung (20) zum Umwandeln von Elektroenergie in Wärme mit einem ersten Umwandlungsmodul (1), umfassend eine erste Widerstandsbaugruppe (6), die mit einer ersten Anschlussklemme (X1) des Umwandlungsmoduls (1) verbunden ist und eine Mehrzahl von Widerstandsscheiben (RS1-3) aufweist, sowie einen ersten Halbleiterschalter (7), mittels dessen ein Stromfluss durch die erste Widerstandsbaugruppe (6) gesperrt oder erlaubt werden kann, und der mit einer zweiten Anschlussklemme (X2) des Umwandlungsmoduls (1) verbunden ist,
**dadurch gekennzeichnet, dass** die Vorrichtung (20) ferner eine zweite Widerstandsbaugruppe (9), die mit der ersten Anschlussklemme (X1) des Umwandlungsmoduls (1) verbunden ist und eine Mehrzahl von Widerstandsscheiben (RS4-6) aufweist, sowie einen zweiten Halbleiterschalter (10) umfasst, mittels dessen ein Stromfluss durch die zweite Widerstandsbaugruppe (9) gesperrt oder erlaubt werden kann, und der mit der zweiten Anschlussklemme (X2) des Umwandlungsmoduls (1) verbunden ist, wobei die Widerstandsscheiben der ersten und der zweiten Widerstandsbaugruppe (6, 9) in einem gemeinsamen Stapel (35) zwischen einer ersten und einer zweiten Kühlplatte (36, 37) angeordnet sind, der nachfolgend als erster Stapel (35) bezeichnet wird, wobei der erste Stapel (35) ferner eine mittlere Kühlplatte (38) aufweist, die die Widerstandsscheiben (RS1-3) der ersten Widerstandsbaugruppe (6) von den Widerstandsscheiben (RS4-6) der zweiten Widerstandsbaugruppe (9) trennt, wobei die erste Kühlplatte (36) mit dem ersten Halbleiterschalter (7), die zweite Kühlplatte (37) mit dem zweiten Halbleiterschalter (10) und die mittlere Kühlplatte (38) mit der ersten Anschlussklemme (X1) des Umwandlungsmoduls (1) elektrisch verbunden sind.

2. Vorrichtung (20) nach Anspruch 1, wobei die erste und die zweite Widerstandsbaugruppe (6, 9) jeweils weitere Widerstandsscheiben umfassen, wobei die weiteren Widerstandsscheiben der ersten und der zweiten Widerstandsbaugruppe in einem gemeinsamen zweiten Stapel (39) zwischen der ersten und der zweiten Kühlplatte (36, 37) angeordnet sind, wobei die mittlere Kühlplatte (38) die weiteren Widerstandsscheiben der ersten Widerstandsbaugruppe von den weiteren Widerstandsscheiben der zweiten Widerstandsbaugruppe trennt und der zweite Stapel (39) parallel zu dem ersten Stapel (35) angeordnet ist.

3. Vorrichtung (20) nach einem der vorangehenden Ansprüche, wobei der ersten Widerstandsbaugruppe (6) eine erste Diode, der zweiten Widerstandsbaugruppe (9) eine Diode parallelgeschaltet sind.

4. Vorrichtung (20) nach einem der vorangehenden Ansprüche, wobei die Widerstandsscheiben (RS1-6) jeweils zylinderförmige Keramik-Kohlenstoff-Widerstandsscheiben sind.

5. Vorrichtung (20) nach einem der vorangehenden Ansprüche, wobei der erste Stapel (35) und/oder der zweite Stapel (39) jeweils höchstens zehn Widerstandsscheiben umfassen.

6. Vorrichtung (20) nach einem der vorangehenden Ansprüche, wobei die erste, zweite und mittlere Kühlplatte (36, 37, 38) an einen gemeinsamen Kühlkreislauf angeschlossen sind.

7. Vorrichtung nach (20) einem der vorangehenden Ansprüche, wobei der erste und der zweite Halbleiterschalter (7, 10) jeweils abschaltbare Halbleiterschalter sind.

8. Vorrichtung (20) nach einem der vorangehenden Ansprüche, wobei das erste Umwandlungsmodul (1) ferner einen Energiespeicher (5) umfasst, der in einer Parallelschaltung zum ersten Halbleiterschalter (7) und der ersten Widerstandsbaugruppe (6) angeordnet ist.

9. Vorrichtung (20) nach einem der vorangehenden Ansprüche, wobei die Vorrichtung ferner ein zweites Umwandlungsmodul (22) umfasst, das elektrisch in Reihe zum ersten Umwandlungsmodul geschaltet ist, wobei das erste und das zweite Umwandlungsmodul (21, 22) in einer Etage einer Tragestruktur (25) angeordnet sind, wobei das zweite Umwandlungsmodul eine dritte Widerstandsbaugruppe (33) und eine vierte Widerstandsbaugruppe (34) umfasst, wobei die dritte Widerstandsbaugruppe (33) in der Tragestruktur (25) oberhalb der ersten Widerstandsbaugruppe (31) und von dieser elektrisch isoliert angeordnet ist und die vierte Widerstandsbaugruppe (34) in der Tragestruktur oberhalb der zweiten Widerstandsbaugruppe (32) und von dieser elektrisch isoliert angeordnet ist.

10. Umrichteranordnung (100) umfassend einen Umrichter (101) mit einer Wechselspannungsseite zum Verbinden mit einem Wechselspannungsnetz und einer Gleichspannungsseite sowie eine Vorrichtung (102) nach einem der vorangehenden Ansprüche, die mit der Gleichspannungsseite des Umrichters (101) verbunden ist.
